Europäisches Patentamt

European Patent Office

Office européen des brevets

(11) Veröffentlichungsnummer: **0 406 693 A2**

## (12) EUROPÄISCHE PATENTANMELDUNG

(21) Anmeldenummer: 90112276.2

(22) Anmeldetag: 27.06.90

(51) Int. Cl.5: **H03H 17/02**

(30) Priorität: 07.07.89 DE 3922469

(43) Veröffentlichungstag der Anmeldung:
**09.01.91 Patentblatt 91/02**

(84) Benannte Vertragsstaaten:
**AT BE CH DE DK ES FR GB GR IT LI LU NL SE**

(71) Anmelder: **Siemens Nixdorf Informationssysteme Aktiengesellschaft Fürstenallee 7**
**D-4790 Paderborn(DE)**

(72) Erfinder: **Kunold, Ingo, Dipl.-Ing..**
**Holsteiner Weg 6**
**D-4799 Borchen 2(DE)**

(74) Vertreter: **Schaumburg, Thoenes & Englaenderder**
**Mauerkircherstrasse 31**
**D-8000 München 80(DE)**

(54) Verfahren zum Filtern digitalisierter Signale.

(57) Ein Verfahren zum Filtern digitaler Eingangssignale (e) verwendet Allpaßfilter erster Art mit der Übertragungsfunktion S1 und Allpaßfilter zweiter Art mit der Übertragungsfunktion S2 sowie aus diesen abgeleitete Allpaßfilter höherer Ordnung mit den Übertragungsfunktionen S1' und S1'' bzw. S2' und S2''. Die Allpaßfilter (10 bis 36) sind in mehreren Stufen so angeordnet, daß die Zahl an Allpaßfiltern höherer Ordnung für eine vorgegebene Filterfunktion verringert wird. Die Ausgangssignale (A1 bis A8) der Allpaßfilter niedrigster Ordnung (22 bis 36) werden in einer Verknüpfungsstufe zu Filterausgangssignalen (d1, d8) verknüpft, deren jeweilige Filtercharakteristik durch die Verknüpfung bestimmt ist. Durch die Erfindung wird erreicht, daß die zur Filterung insgesamt benötigten Verfahrensschritte schneller als beim Stand der Technik ausgeführt werden.

Fig.1

EP 0 406 693 A2

## VERFAHREN ZUM FILTERN DIGITALISIERTER SIGNALE

Die Erfindung betrifft ein Verfahren zum Filtern digitalisierter Signale, bei dem ein Eingangssignal von mindestens einem Allpaßfilter erster Art und mindestens einem Allpaßfilter zweiter Art sowie von aus diesen Allpaßfiltern durch Frequenztransformation abgeleiteten Allpaßfiltern höherer Ordnung gefiltert wird und bei dem mindestens ein Filterausgangssignal durch substraktive und/oder additive Verknüpfung der Ausgangssignale der Allpaßfilter erzeugt wird.

Ein derartiges Verfahren ist aus der DE 36 27 676 Al bekannt und dient dazu, ein verzerrtes Signal, beispielsweise ein Audiosignal, zu filtern und dieses in vorbestimmten Frequenzbereichen zu entzerren. Hierzu wird ein kontinuierliches Signal in eine Folge diskreter Digitalwerte gewandelt, diese der Filterung unterzogen und, falls gewünscht, anschließend wieder in ein kontinuierliches Signal rückgewandelt. An die Verarbeitung der Digitalwerte in einem Digitalrechner werden Anforderungen gestellt, die nur schwer gleichzeitig zu erfüllen sind. So soll die Verarbeitungsgeschwindigkeit sehr hoch sein, um möglichst in Echtzeit Signale hoher Frequenz verarbeiten zu können. Dies läßt sich jedoch nur mit Hilfe einfacher Filterstrukturen, die einen geringen Rechenaufwand benötigen, erreichen. Andererseits soll die Selektion des Filters hoch sein, was wiederum nur mit aufwendigen Filterstrukturen, d.h. mit Filtern höherer Ordnung, und entsprechend großem Rechenaufwand möglich ist.

Das in der DE 36 27 676 Al beschriebene Verfahren verwendet zum Aufbau von sogenannten Wellendigitalfiltern Allpaßfilter erster und zweiter Art. Diese Allpaßfilter unterscheiden sich um mindestens eine Ordnung, d.h. das Allpaßfilter zweiter Art hat die Ordnung zwei, wenn das Allpaßfilter erster Art die Ordnung 1 hat. Es können aber auch Allpaßfilter mit höheren Ordnungen verwendet werden. Durch Anwenden der aus der digitalen Filtertechnik bekannten Frequenztransformationen können aus den Allpaßfiltern erster sowie zweiter Art weitere Allpaßfilter nächsthöherer Ordnung abgeleitet werden, deren Ordnung durch die verwendete Frequenztransformation bestimmt ist.

Enthält eine Filteranordnung nur ein Allpaßfilter erster und zweiter Art, so wird der durch das Abtasttheorem definierte Frequenzbereich in zwei Teilbänder aufgeteilt. Werden zusätzlich zu diesen Allpaßfilter höherer Ordnung eingesetzt, so wird die Zahl der Teilbänder erhöht und damit eine verbesserte Selektion bei der Filterung erreicht. Bekanntlich steigt der Rechenaufwand für die Filterung durch ein Allpaßfilter mit zunehmender Ordnung an, da umfangreichere und damit zeitaufwendigere Rechenschritte durchgeführt werden müssen als bei Filtern niedrigerer Ordnung. Beim bekannten Verfahren sind zur Zerlegung in eine vorgegebene Zahl von gleichgroßen Teilbändern die Allpaßfilter in Kaskadierungsstufen so zusammengefaßt, daß die benötigte Zahl an Allpaßfiltern höherer Ordnung größer ist als die Zahl an Allpaßfiltern niedrigerer Ordnung. Dies führt dazu, daß die Filterung zeitaufwendig ist.

Es ist daher Aufgabe der Erfindung, ein neues Verfahren zum Filtern digitalisierter Signale anzugeben, bei dem die Zahl der für eine vorgegebene Filterfunktion benötigten Allpaßfilter höherer Ordnung verringert wird.

Diese Aufgabe wird für ein Verfahren eingangs genannter Art dadurch gelöst, daß das Eingangssignal jeweils einem Allpaßfilter der ersten sowie der zweiten Art und jeweils höchster Ordnung zugeführt wird, deren Ausgangssignale dann jeweils einem direkt nachgeschalteten Allpaßfilter der ersten und der zweiten Art und jeweils nächstniedrigerer Ordnung zugeführt werden, daß diese Zuführung an Allpaßfilter der nächstniedrigeren Ordnung bis zum Erreichen von Allpaßfiltern niedrigster Ordnung wiederholt wird, und daß ausschließlich die Ausgangssignale der Allpaßfilter niedrigster Ordnung zum Filterausgangssignal verknüpft werden.

Bei der Erfindung sind jedem Allpaßfilter höchster Ordnung zwei Allpaßfilter nächstniedrigerer Ordnung nachgeschaltet, diesen jeweils zwei Allpaßfilter nächstniedrigerer Ordnung und so fort bis zum Erreichen von Allpaßfiltern niedrigster Ordnung. Dies bedeutet, daß die Zahl der Allpaßfilter mit absteigender Ordnung zunimmt. Beim erfindungsgemäßen Verfahren bleibt zwar die Zahl der insgesamt zur Filterung zu verwendenden Allpaßfilter genau so groß wie beim bekannten Verfahren, jedoch verringert sich die Zahl der Allpaßfilter höherer Ordnung, während sich die Zahl der Allpaßfilter niedrigerer Ordnung erhöht. Damit wird der bei der technischen Realisierung benötigte Aufwand im Digitalrechner von zeitaufwendigen Multiplikationsoperationen hin zu einfacheren und schnelleren Summen-und Differenzoperationen verlagert, wobei die Filterwirkung erhalten bleibt. Diese Verlagerung ermöglicht es, die insgesamt benötigten Verfahrensschritte schneller als beim bekannten Verfahren auszuführen, wodurch eine höhere Signalverarbeitungsgeschwindigkeit erreicht wird.

Das Filterausgangssignal wird durch Summen-und/oder Differenzbildung der Ausgangsignale der Allpaßfilter niedrigster Ordnung erzeugt. Beim Ergebnis dieser Verknüpfung sind zwei Extremfälle zu unterscheiden. In einem Fall (Durchlaßbereich) addieren sich die Ausgangssignale zu einem Filterausgangssignal, dessen Betrag zum Eingangssignal proportional ist. Im anderen Fall (Sperrbereich) addieren sich die Ausgangssignale zu Null, d.h. das Eingangssignal wird bei der Filterung nicht durchgelassen sondern gesperrt. Diese Vorgänge sind abhängig von der Frequenz des Eingangssignals und führen zu einem bestimmten Frequenzverhalten des Filterausgangssignals. Durch Variieren der Verknüpfung der Ausgangssignale wird jeweils die Filtercharakteristik des Filterausgangssignals verändert. Es ist daher möglich, mehrere Filterausgangssignale mit voneinander verschiedenen Frequenzverhalten zu erzeugen. Wird zum Beispiel eine digitale Filterung mit je einem Allpaßfilter erster und zweiter Art und höherer Ordnung durchgeführt, denen vier Allpaßfilter niedrigster Ordnung nachgeschaltet sind, so werden von den letzteren vier Ausgangssignale erzeugt, die durch Variieren der Verknüpfung zu maximal 16 voneinander verschiedenen Filterausgangssignalen verknüpft werden können. Als Filtercharakteristik erhält man dann z.B. einen Tiefpaß, einen Bandpaß mit einer ersten Mittenfrequenz, einen weiteren Bandpaß mit einer zweiten höheren Mittenfrequenz, einen Hochpaß sowie vier weitere Filtercharakteristiken, die jeweils den vorgenannten entsprechen und jeweils um 180° phasenverschobene Filterausgangssignale haben.

Weiterhin ist es möglich, die Filtercharakteristik eines Filterausgangssignals auf schnelle Art und Weise einzustellen oder abzuändern. Hierzu muß lediglich im letzten Verfahrensschritt der Filterung eine entsprechende Verknüpfung eingestellt werden. Die vorangegangenen Verarbeitungsschritte der digitalen Filterung müssen zur Änderung der Filtercharakteristik des Filterausgangssignals nicht verändert werden. Dies bedeutet, daß die Allpaßfilter eingeschwungen bleiben. Folglich muß das Filterausgangssignal beim Ändern seiner Filtercharakteristik keinen Einschwingvorgang durchlaufen. Diese Eigenschaft kann in vorteilhafter Weise bei zeitkritischen Anwendungen genutzt werden.

Bei einer bevorzugten Weiterbildung der Erfindung werden die Ausgangssignale der Allpaßfilter niedrigster Ordnung jeweils mit einem Koeffizienten gewichtet. Dadurch wird erreicht, daß die Filtercharakteristik bei der digitalen Filterung auch durch Ändern der Koeffizienten eingestellt werden kann. Beispielsweise ist es möglich, durch Abändern eines Koeffizienten die Filtercharakteristik eines Filterausgangssignals von Bandpaßverhalten in Bandsperrverhalten umzukehren.

Hierzu kann es vorteilhaft sein, das Ausgangssignal des Allpaßfilters niedrigster Ordnung, dem nur Allpaßfilter der selben Art vorgeschaltet sind, mit einem Koeffizienten zu wichten, dessen Wert zusammen mit den Werten der untereinander gleich großen Koeffizienten, mit denen die verbleibenden Ausgangssignale gewichtet werden, Null ergibt. Durch diese Maßnahmen wird die Filtercharakteristik eines Sperrfilters erzeugt, wobei entweder das Ausgangssignal des Allpaßfilters der ersten Art oder der zweiten Art jeweils niedrigster Ordnung mit dem Koeffizienten zu multiplizieren ist, der sich von den anderen Koeffizienten unterscheidet.

Ferner kann es sinnvoll sein, die Ausgangssignale der Allpaßfilter niedrigster Ordnung jeweils wahlweise zu invertieren. Durch diesen einfachen Eingriff in den Verfahrensablauf der Filterung wird es möglich, die Filtercharakteristik eines bestimmten Filterausgangssignals in seine inverse Filtercharakteristik umzukehren, ohne daß die Verknüpfung geändert werden muß. Das Invertieren sowie das Gewichten wird vorteilhafterweise von einer Filtersteuerung gesteuert. In dieser können z.B. die möglichen Kombinationen der Verknüpfungen in einer Tabelle zusammengefaßt und gespeichert sein. Durch Zugriff auf diese Steuerung lassen sich so die gewünschten Filtercharakteristiken der Filterausgangssignale auf einfache Weise einstellen.

Ferner ist es in bestimmten Anwendungsfällen sinnvoll, daß die Gewichtung mit gleichgroßen Koeffizienten erfolgt, deren Summe 1 ergibt. Dadurch wird der Betrag der Übertragungsfunktion für die Filterausgangssignale innerhalb des Durchlaßbereichs der Filtercharakteristik gleich 1, d.h. Eingangssignal und Filterausgangssignal haben die gleiche Amplitude. Ferner wird durch diese Maßnahme erreicht, daß die Filterausgangssignale innerhalb eines vorgegebenen Wertebereichs liegen und nicht übersteuert werden.

Vorteilhaft ist es auch, wenn die Verfahrensschritte der Filterung und der Verknüpfung von einem Signalprozessor durchgeführt werden. Diese Verfahrensschritte sind besonders gut an den Datenverarbeitungsablauf eines Signalprozessors angepaßt, so daß die Verarbeitungsgeschwindigkeit bei der Filterung weiter erhöht werden kann. Insbesondere ist der Einsatz eines Signalprozessors zweckmäßig, dessen Rechenwerk Mehrfachadditionen ausführen kann. Solche Rechenoperationen kommen bei der Verknüpfung der Ausgangssignale der Allpaßfilter niedrigster Ordnung zum Filterausgangssignal vor. Durch diese Weiterbildung wird die Geschwindigkeit bei der Signalverarbeitung zur Filterung weiter erhöht.

Ausführungsbeispiele der Erfindung werden im folgenden anhand der Zeichnung erläutert. Darin zeigt:

Figur 1 eine schematische Darstellung eines Ausführungsbeispiels der Erfindung in einem Blockschaltbild,

Figur 2 zwei idealisierte Verläufe von Übertragungsfunktionen, die sich aufgrund der Verknüpfung nach der Figur 1 ergeben,

Figur 3 eine weiter Anwendung der Erfindung mit steuerbarer Verknüpfung,

Figur 4 vier idealisierte Verläufe von Übertragungsfunktionen, die sich aufgrund der in Figur 3 gezeigten Verknüpfung ergeben,

Figur 5 ein Allpaßfilter erster Art mit der Übertragungsfunktion S1 und daraus durch Frequenztransformation abgeleitete Allpaßfilter höherer Ordnung, und

Figur 6 ein bireziprokes Allpaßfilter zweiter Art mit der Übertragungsfunktion S2 und daraus abgeleitete Allpaßfilter höherer Ordnung.

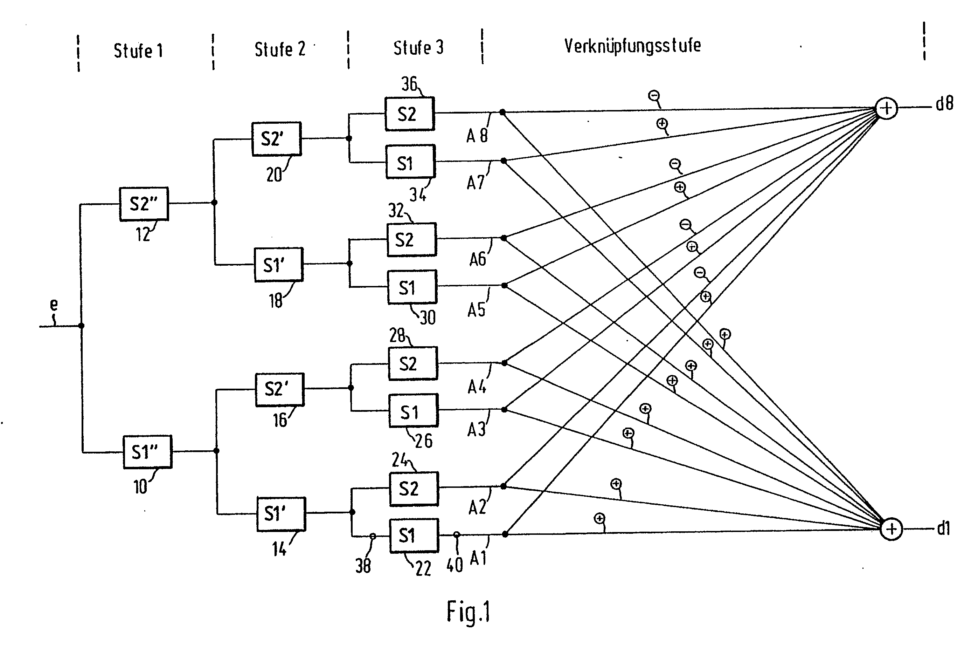

In Figur 1 ist ein Ausführungsbeispiel der Erfindung in einem Blockdiagramm schematisch dargestellt. Mehrere Allpaßfilter 10 bis 36 sind in drei Stufen miteinander verschaltet, an die sich eine Verknüpfungsstufe anschließt. Die Allpaßfilter 10 bis 36, deren Aufbau später noch genauer erläutert wird, haben jeweils einen Eingangsanschluß und einen Ausgangsanschluß, die aus Gründen der besseren Übersicht beispielhaft nur beim Allpaßfilter 22 mit 38 bzw. 40 bezeichnet sind. Es werden zwei Arten von Allpaßfiltern verwendet, Allpaßfilter der ersten Art, deren Übertragungsfunktion mit S1 bezeichnet wird, sowie Allpaßfilter der zweiten Art, deren Übertragungsfunktion mit S2 bezeichnet wird. Aus diesen Allpaßfiltern, deren Ordnung 1 oder auch größer sein kann, werden durch bekannte Transformationsvorschriften, die auch als Frequenztransformation bezeichnet werden, Allpaßfilter höherer Ordnung abgeleitet. Die Übertragungsfunktionen abgeleiteter Allpaßfilter werden mit $S1'$ bzw. $S2'$ bei einmaliger Anwendung der Frequenztransformation und mit $S1''$ bzw. $S2''$ bei zweimaliger Anwendung der Frequenztransformation bezeichnet.

Gemäß der Figur 1 wird ein digitales Eingangssignal e den Allpaßfiltern 10 und 12 zugeführt, die durch zweimaliges Anwenden der Frequenztransformation abgeleitet worden sind. Das Ausgangssignal des Allpaßfilters 10 wird den Allpaßfiltern 14 und 16 zugeführt, die durch einmalige Anwendung der Frequenztransformation entstanden sind. Analoges gilt für das Ausgangssignal des Allpaßfilters 12, dessen Ausgang mit den Eingängen der Allpaßfilter 18 und 20 direkt verbunden ist. Die Ausgangssignale der Allpaßfilter 14 bis 20 werden jeweils einem Allpaßfilter 22 und 24 bzw. 26 und 28 bzw. 30 und 32 bzw. 34 und 36 der ersten Art bzw. der zweiten Art zugeführt, die daraus Ausgangssignale A1 bis A8 erzeugen.

Anhand der Figur 1 ist zu erkennen, daß die Allpaßfilter 10 bis 36 nach einem bestimmten Schema verschaltet sind, bei dem in einer Stufe 1 Allpaßfilter höchster Ordnung, in einer Stufe 2 Allpaßfilter nächstniedrigerer Ordnung und in einer Stufe 3 Allpaßfilter niedrigster Ordnung angeordnet sind. Die Anzahl der zu verwendenden Allpaßfilter nimmt von Stufe zu Stufe zu, wobei in der ersten Stufe zwei Allpaßfilter und in der n-ten Stufe $2^n$ Allpaßfilter vorgesehen sind.

Die zur stufenweisen Filterung des digitalen Eingangssignals e in den Allpaßfiltern 10 bis 36 erforderlichen Filteroperationen werden im allgemeinen in einen Digitalrechner (nicht dargestellt) durchgeführt. Eine spezielle Ausführungsform eines Digitalrechners, der für die Zwecke der digitalen Filterung besonders gut geeignet ist, stellt ein Signalprozessor dar. Dessen Rechenwerk ist so ausgelegt, daß die bei der digitalen Filterung häufig vorkommenden Rechenoperationen wie Multiplikation, Addition, Subtraktion und Zwischenspeicherung von Teilergebnissen besonders schnell durchgeführt werden können. Dennoch bildet die für die Filterung erforderliche Rechenzeit des Signalprozessors den technologischen Engpaß in der digitalen Filterungstechnik. Bekanntlich steigt der Rechenaufwand mit zunehmender Ordnung der Filter an. Beim vorliegenden Verfahren wird dieser Aufwand klein gehalten, da die Filter höchster Ordnung in der Stufe 1 angeordnet sind, d.h. die Zahl dieser Filter auf einen Minimalwert reduziert wird. Die Zunahme an Verknüpfungsoperationen in der Verknüpfungsstufe fällt dagegen nicht ins Gewicht.

Nach der stufenweisen Filterung des Eingangssignals e im Digitalrechner liegen acht Ausgangssignale A1 bis A8 vor, die in der nachfolgenden Verknüpfungsstufe durch Addition und/oder Subtraktion zu Filterausgangssignalen verknüpft werden. Unter der Vielzahl möglicher Kombinationen an Verknüpfungen sind nur zwei dargestellt, die zu den Filterausgangssignalen d1 und d8 führen. Das Ausgangssignal d8 wird hierbei durch Addition der Ausgangssignale A1, A3, A5, A7 und Subtraktion der Ausgangssignale A2, A4, A6, A8 erzeugt. Das Ausgangssignal d1 wird durch Addition aller Ausgangssignale A1 bis A8 erzeugt.

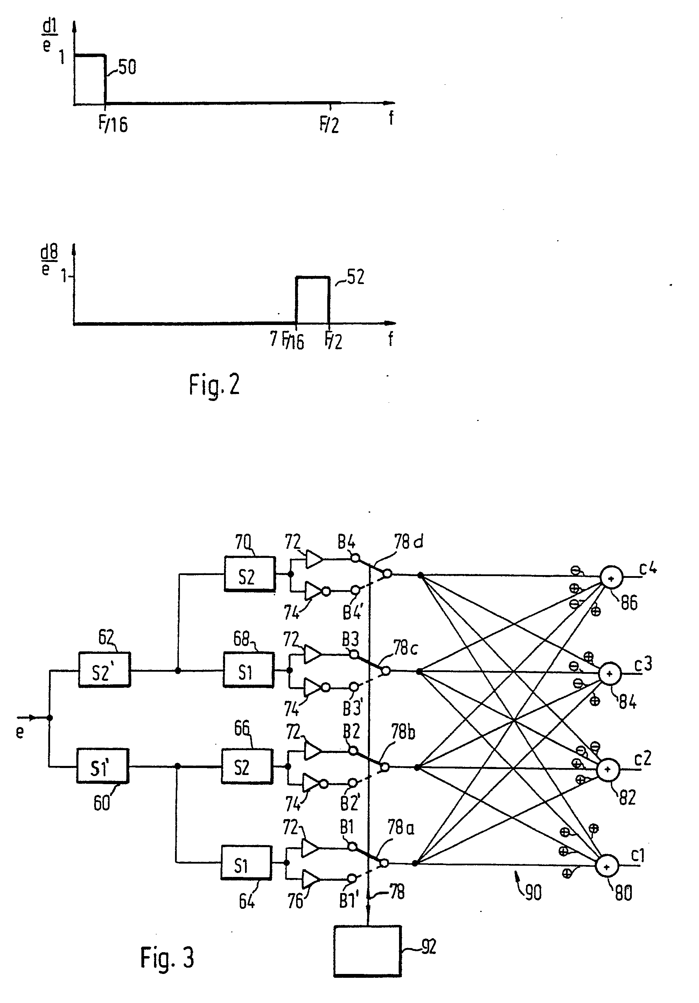

In Figur 2 sind zwei idealisierte Übertragungsfunktionen d1/e bzw. d8/e über der Frequenz f dargestellt, die die Filterwirkung auf die Filterausgangssignale d1 und d8 bei einer Verknüpfung nach der Figur 1 wiedergeben. Das Filterausgangssignal d1 hat einen Frequenzgang, der einer Tiefpaßfilterung mit der Filtercharakteristik 50 entspricht, das Filterausgangssignal d8 hat einen Frequenzgang, der einer Bandpaßfilterung mit Filtercharakteristik 52 entspricht. Die Grenzfrequenzen der Filtercharakteristiken 50, 52 sind jeweils von der Abtastfrequenz F abhängig, mit der die diskreten Eingangssignale e aus einem kontinuierlichen Signal durch Analog/Digitalwandlung gewonnen werden. Weitere Filterausgangssignale mit anderem Filterverhalten lassen sich durch Abändern der Verknüpfungsoperationen erzeugen. Beispielsweise können Ausgangssignale erzeugt werden, deren jeweilige Filterkurve einem Bandpaß nach Art der Filtercharakteristik 52 entspricht, wobei die Mittenfrequenz fm im Bereich 1/32 F<fm<15/32 F ist.

In Figur 3 ist eine andere Ausführungsform nach der Erfindung dargestellt. Das Eingangssignal e wird nach Art der bereits beschriebenen Filterung in mehreren Stufen mit Hilfe von Allpaßfiltern 60 bis 70 gefiltert. Bei diesem Ausführungsbeispiel findet die Filterung in zwei Stufen statt. Im Unterschied zu der in Figur 1 gezeigten Anordnung werden die Signale der Allpaßfilter niedrigster Ordnung 64, 66, 68, 70, 72 zunächst Multiplizierbausteinen 72 sowie negierenden Multiplizierbausteinen 74 zugeführt, die durch Gewichtung oder Multiplikation mit einem Koeffizienten $b_1$ die Ausgangssignale $B_1$ bis $B_4$ bzw. $B_2'$ bis $B_4'$ erzeugen. Das Ausgangssignal $B_1'$ wird abweichend von diesem Schema durch Multiplikation des vom Allpaßfilter 64 abgegebenen Signals mit einem Koeffizienten $b_2$ in einem Multiplizierbaustein 76 erzeugt. Die Koeffizienten $b_1$ und $b_2$ können so gewählt werden, daß deren Multiplikation mit den entsprechenden Ausgangssignalen durch ein einfaches Verschieben von Bitstellen im Digitalrechner realisiert wird. Dies ist z.B. bei Koeffizienten mit dem Wert $2^n$ mit $n = -1, -2, -3, \ldots$ der Fall. Die Ausgangssignale $B_1$ bis $B_4$ bzw. $B_1'$ bis $B_4'$ werden über Schaltelemente 78a bis 78d einer Schaltanordnung 78 einem Verknüpfungsnetzwerk 90 zugeführt. Die Schalterstellung der Schalteranordnung 78 wird von einer Filtersteuerung 92 gesteuert.

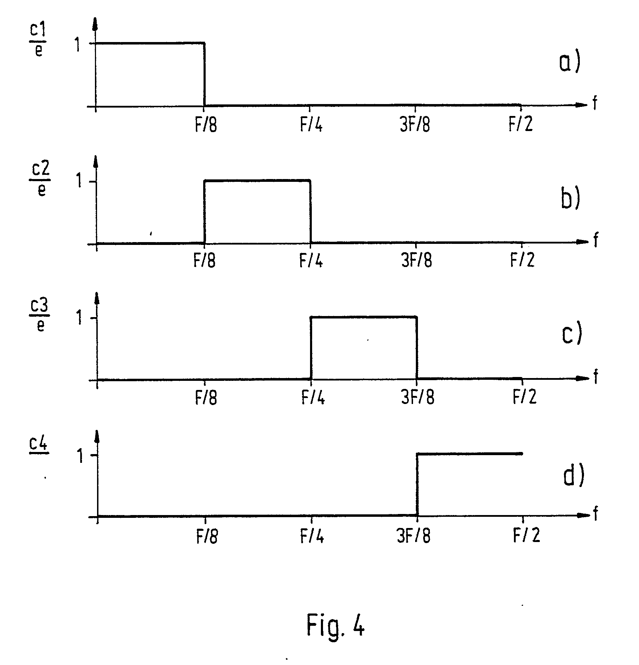

Bei der in Figur 3 gezeigten Schalterstellung werden durch Verknüpfen der Ausgangssignale $B_1$ bis $B_4$ im Verknüpfungsnetzwerk 90 entsprechend den eingezeichneten Vorzeichen unter Verwendung von Summiergliedern 80 bis 86 Filterausgangssignale $c_1$ bis $c_4$ erzeugt. Das Frequenzverhalten dieser Ausgangssignale $c_1$ bis $c_4$ kann den in der Figur 4 dargestellten idealisierten Übertragungsfunktionen über der Frequenz $f$ entnommen werden. Die Übertragungsfunktion $c_1/e$ in Figur 4a entspricht der eines Tiefpaßfilters mit Grenzfrequenz F/8, wobei F, wie bereits erwähnt, die Abtastfrequenz ist. Die in den Figuren 4b bzw. 4c gezeigten Übertragungsfunktionen $c_2/e$ bzw. $c_3/e$ entsprechen Bandpaßfiltern mit F/8<fd<2F/8 bzw. 2F/8<fd<3F/8. In Figur 4c ist die Übertragungsfunktion $c_4/e$ dargestellt, die einem Hochpaß mit der unteren Grenzfrequenz 3F/8 entspricht. Werden die Koeffizienten $b_1$ der Multiplizierbausteine 72 auf den Wert 1/4 eingestellt, so ist die Summe aller wirksamen Koeffizienten gleich 1 und damit auch der Betrag der Übertragungsfunktionen $c_1/e$ bis $c_4/e$ im Durchgangsbereich gleich 1. Durch Ändern der Koeffizienten $b_1$ kann die Amplitude der Ausgangssignale $c_1$ bis $c_4$ beeinflußt werden.

Wenn die Filtersteuerung 92 die Schaltelemente 78a bis 78d in die in Figur 3 gestrichelt gezeichnete Schaltstellung umschaltet, so werden die Ausgangssignale $B_1'$ bis $B_4'$ durch das Verknüpfungsnetzwerk 90 zu den Filterausgangssignalen $c_1$ bis $c_4$ verknüpft. Werden dabei die Koeffizienten $b_1$ der invertierenden Multiplikationsbausteine 74 auf den Wert 1/4 und der Koeffizient $b_2$ des Multiplikationsbausteins 76 auf den Wert 3/4 eingestellt, so kehren sich die in Figur 4 dargestellten Frequenzgänge der Filterausgangssignale $c_1$ bis $c_4$ um, d.h. aus dem in Figur 4a gezeigten Tiefpaß wird ein Hochpaß, aus den Bandpässen der Figuren 4b und 4c werden Bandsperren und aus dem Hochpaß gemäß der Figur 4c wird ein Tiefpaß. In einer nicht dargestellten Weiterbildung können die Schalterelemente 78a bis 78b durch die Filtersteuerung 92 individuell angesteuert werden. Dadurch kann der jeweilige Frequenzgang der Ausgangssignale $c_1$ bis $c_4$ schnell auf den gewünschten Verlauf eingestellt werden, ohne daß in die Struktur des Verknüpfungsnetzwerkes eingegriffen werden muß.

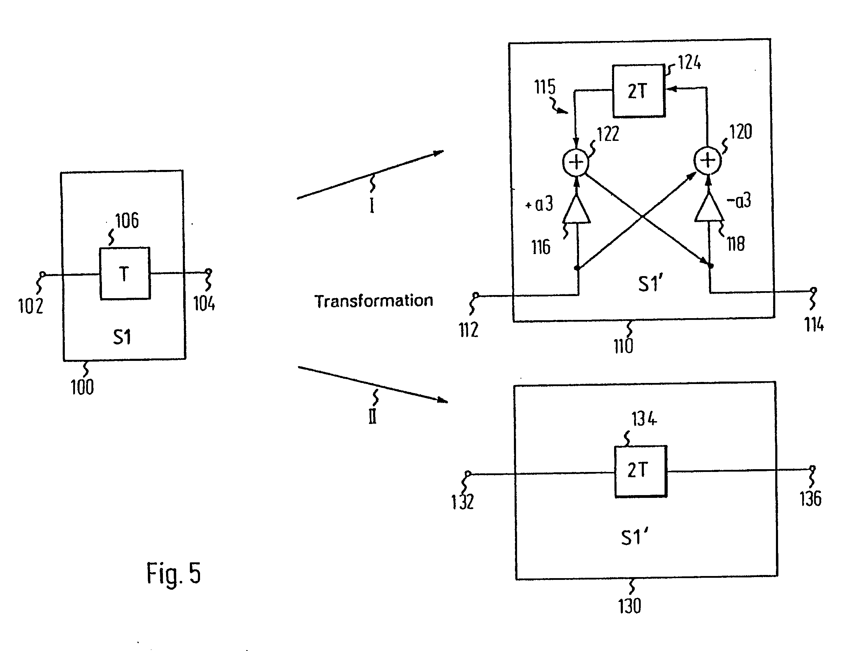

Die Figuren 5 bis 7 zeigen Allpaßfilter, die zur stufenweisen Filterung des Eingangssignals e gemäß den Figuren 1 und 3 verwendet werden können. In Figur 5 sind Allpaßfilter 100, 110 und 130 der ersten Art dargestellt. Das Verhalten der Allpaßfilter wird durch ihre Übertragungsfunktion bestimmt. Das Allpaßfilter 100 der ersten Ordnung hat eine Übertragungsfunktion $S_1$. Zwischen seinem Eingangsanschluß 102 und seinem Ausgangsanschluß 104 ist ein Verzögerungsglied 106 angeordnet, das ein über den Eingangsanschluß 102 zugeführtes Signal um einen Zeittakt T verzögert, der dem Kehrwert der Abtastfrequenz F entspricht. Mit Hilfe bekannter Frequenztransformationen können aus dem Allpaßfilter 100 der ersten Ordnung weitere Allpaßfilter höherer Ordnung abgeleitet werden. Bei Anwendung der allgemeinen Filtertransformation, angedeutet durch den Pfeil I, entsteht ein Allpaßfilter 110 zweiter Ordnung mit der Übertragungsfunktion $S_1'$, bei dem zwischen einem Eingangsanschluß 112 und einem Ausgangsanschluß 114 ein digitales Filternetzwerk 115 angeordnet ist. Ein über den Eingangsanschluß 112 zugeführtes Signal wird einem Multiplikationsbaustein 116 zugeführt, das das Signal mit einem Koeffizienten $a_3$ multipliziert und das Ergebnis an ein Addierglied 122 weitergibt. Dieses erzeugt durch Summation einer weiteren Signalkomponente, die von einem Verzögerungsglied 124 abgegeben wird, ein Signal, das einerseits dem Ausgangsanschluß 114 zugeführt und andererseits über einen Multiplikationsbaustein 118 in das Netzwerk 115 rückgeführt wird. Der Multiplikationsbaustein 118 führt eine Multiplikation mit einem Koeffizienten $-a_3$ aus und leitet das Ergebnis an ein Addierglied 120 weiter, das zu diesem Ergebnis das am Eingangsanschluß 112 anliegende Signal addiert. Das Resultat wird im Verzögerungsglied 124 um zwei Takte T verzögert und schließlich dem Addierglied 122 zugeführt. Die in diesem Beispiel angewandte Frequenztransformation wird nach der bekannten Vorschrift gebildet

$$z' = (a3z^2 + 1)(z^2 + a3)^{-1} \text{ mit}$$
$$z = e^{pT},$$

worin p die komplexe Frequenz und T die Abtastperiode ist.

Bei Anwenden einer anderen bekannten Frequenztransformation mit der Vorschrift $z' = z^2$ (angedeutet durch einen Pfeil II in Figur 5) entsteht das Allpaßfilter 130 zweiter Ordnung mit der Übertragungsfunktion S1'. Dieses gibt ein an seinem Eingangsanschluß 132 anliegendes Signal um zwei Zeittakte T verzögert an seinen Ausgangsanschluß 136 ab. Die Zeitverzögerung bewirkt ein Verzögerungsglied 134.

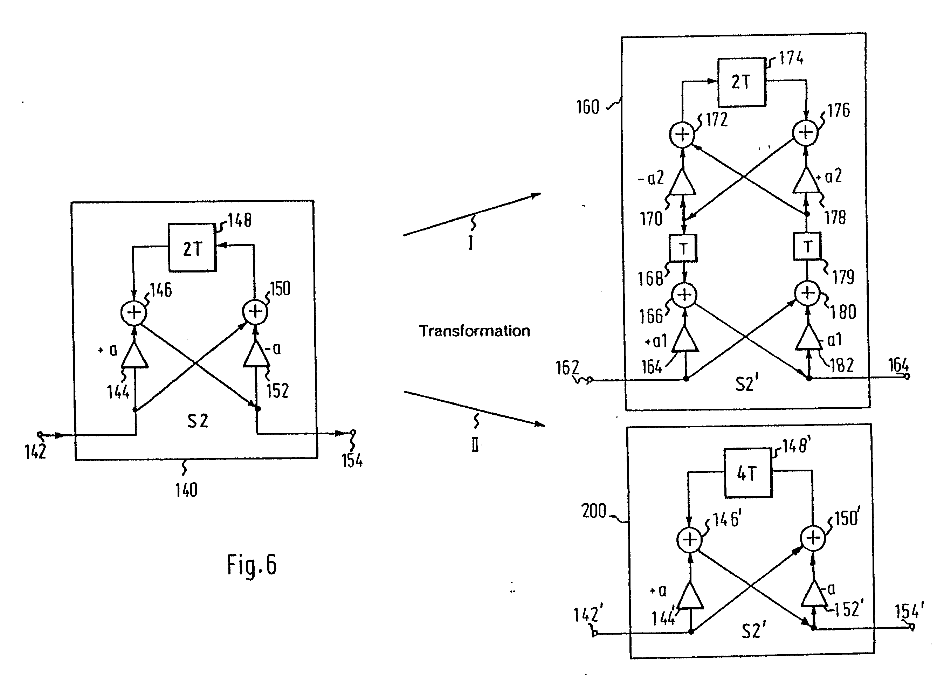

In Figur 6 sind bireziproke Allpaßfilter zweiter Art dargestellt, d.h. Allpaßfilter, deren Gruppenlaufzeiten spiegelsymmetrisch zu F/4 sind. Ein Allpaßfilter 140 hat die Übertragungsfunktion S2, deren Grad gegenüber der Übertragungsfubktion S1 um eins höher ist.

Ein am Eingangsanschluß 142 ankommendes Signal wird einem Multiplizierbaustein 144 zugeführt, der es mit einem Koeffizienten a multipliziert. Das Ergebnis wird an ein Addierglied 146 weitergegeben, das zu diesem Ergebnis ein von einem Verzögerungsglied 148 abgegebenes Signal addiert und die Summe sowohl dem Ausgangsanschluß 154 als auch einem Multiplizierbaustein 152 zuführt. Dieser multipliziert das Signal mit einem Koeffizienten -a und gibt das Ergebnis an ein Addierglied 150 weiter, das die Summe aus dem am Eingangsanschluß 142 anliegenden Signal und dem Signal des Bausteins 152 bildet. Das Ergebnis wird an das Verzögerungsglied 148 weitergegeben, das es um zwei Takte T verzögert und an das Addierglied 146 weiterreicht.

Durch Anwenden von Frequenztransformationen können aus dem Allpaßfilter 140 der ersten Ordnung Allpaßfilter höherer Ordnung abgeleitet werden. Bei Anwenden einer ersten Frequenztransformation, angedeutet durch den Pfeil I, erhält man das Allpaßfilter 160. Das am Eingangsanschluß 162 ankommende digitalisierte Signal wird einem Multiplizierbaustein 164 zugeführt, der dieses mit einem Koeffizienten al multipliziert. Das Ergebnis wird an ein Addierglied 166 weitergeleitet, das dieses mit dem um einen Takt T verzögerten Signal des Verzögerungsglieds 168 addiert und die Summe an den Ausgangsanschluß 164 und an einen Multiplizierbaustein 182 abgibt. Letzterer multipliziert diese Summe mit einem Koeffizienten -a1. Zum Ergebnis wird in einem Addierglied 180 das Eingangssignal addiert und die Summe in einem Verzögerungsglied 179 um einen Zeittakt T verzögert. Die zeitverzögerte Summe wird in einem weiteren Multiplizierbaustein 178 mit dem Koeffizienten a2 multipliziert. Das Ergebnis wird in einem Addierglied 176 zu einem in einem Verzögerungsglied 174 um zwei Takte T verzögerten Signal addiert und die Summe sowohl an das Verzögerungsglied 168 als auch an einen Multiplizierbaustein 170 abgegeben, der dieses mit einem Koeffizienten -a2 multipliziert und das Ergebnis einem Addierglied 172 zuführt. Dieses bildet die Summe aus dem vorgenannten Ergebnis und dem Ausgangssignal des Verzögerungsglieds 179 und führt die Summe dem Verzögerungsglied 174 zu.

Durch Anwenden der Transformation $z' = z^2$ entsteht das Allpaßfilter 200. Dieses ist analog zum Allpaßfilter 140 aufgebaut (gleiche Teile haben gleiche gestrichene Bezugszeichen), lediglich mit dem Unterschied, daß das Verzögerungsglied 148' um vier Zeittakte T verzögert.

Anhand der Figuren 5 und 6 läßt sich feststellen, daß die Filterstrukturen der Allpässe höherer Ordnung aufwendiger sind als die niedrigerer Ordnung. Dies trifft insbesondere bei Anwendung allgemeiner Frequenztransformationen zu. Im vorliegenden Beispiel wurden nur bireziproke Allpaßfilter behandelt. Es können auch nicht bireziproke Allpaßfilter verwendet werden. Diese haben bereits als Filter erster Ordnung einen aufwendigeren Aufbau. Die durch Transformation aus diesen Filtern abgeleiteten Allpaßfilter höherer Ordnung haben mit zunehmender Ordnung aufwendigere Strukturen. Beim Verfahren nach der Erfindung wird die für die Filterung benötigte Zahl von Allpaßfiltern höherer Ordnung minimiert und damit auch der Rechenaufwand. Dieser Vorteil kommt mit steigender Ordnung der Allpaßfilter immer stärker zur Wirkung.

**Ansprüche**

1. Verfahren zum Filtern digitalisierter Signale, bei dem ein Eingangssignal von mindestens einem Allpaßfilter erster Art und mindestens einem Allpaßfilter zweiter Art sowie von aus diesen Allpaßfiltern durch Frequenztransformationen abgeleiteten Allpaßfiltern höherer Ordnung gefiltert wird und bei dem mindestens ein Filterausgangssignal durch subtraktive und/oder additive Verknüpfung der Ausgangssignale der Allpaßfilter erzeugt wird,
dadurch **gekennzeichnet**,
daß das Eingangssignal (e) jeweils einem Allpaßfilter der ersten (10, 60) sowie der zweiten Art (12, 62) und höchster Ordnung zugeführt wird, deren Ausgangssignale dann jeweils einem direkt nachgeschalteten Allpaßfilter der ersten (14, 18, 66, 70) und der zweiten Art (16, 20, 66, 70) und nächstniedrigerer Ordnung zugeführt werden, daß diese Zuführung an Allpaßfilter der nächstniedrigeren Ordnung bis zum Erreichen von Allpaßfiltern niedrigster Ordnung (22 bis 36, 64 bis 70) wiederholt wird, und daß ausschließlich die Ausgangssignale (A1 bis A8, B1 bis B4, B1' bis B4') der Allpaßfilter niedrigster Ordnung (22 bis 36, 64 bis 70) zum Filterausgangssignal (d1, d8, c1 bis c4) verknüpft werden.

2. Verfahren nach Anspruch 1,
dadurch **gekennzeichnet**,
daß die Ausgangssignale der Allpaßfilter niedrigster Ordnung jeweils mit einem Koeffizienten (b1, b2) gewichtet werden.

3. Verfahren nach Anpruch 2,
dadurch **gekennzeichnet**,
daß das Ausgangssignal des Allpaßfilters niedrigster Ordnung, dem nur Allpaßfilter derselben Art vorgeschaltet sind, mit einem Koeffizienten gewichtet wird, dessen Wert zusammen mit der Summe der Werte der gleich großen Koeffizienten, mit denen die verbleibenden Ausgangssignale gewichtet werden, Null ergibt.

4. Verfahren nach Anspruch 2,
dadurch **gekennzeichnet**,
daß die Gewichtung mit gleichgroßen Koeffizienten (b1) erfolgt.

5. Verfahren nach Anspruch 2 oder 4,
dadurch **gekennzeichnet**,
daß die Gewichtung mit Koeffizienten (b1) durchgeführt wird, deren Summe 1 ergibt.

6. Verfahren nach einem der vorhergehenden Ansprüche,
dadurch **gekennzeichnet**,
daß die Ausgangssignale der Allpaßfilter niedrigster Ordnung (64 bis 70) jeweils wahlweise invertiert werden.

7. Verfahren nach einem der Ansprüche 2 bis 6,
dadurch **gekennzeichnet**,
daß das Gewichten und/oder Invertieren von einer Filtersteuerung (92) gesteuert wird.

8. Verfahren nach einem der vorhergehenden Ansprüche,
dadurch **gekennzeichnet**,
daß die Filterung und Verknüpfung von einem Signalprozessor durchgeführt werden.

9. Verfahren nach einem der vorhergehenden Ansprüche,
dadurch **gekennzeichnet**,
daß die Allpaßfilter höherer Ordnung (10 bis 20, 60, 62, 130, 200) aus einer Frequenztransformation z $= z^2$ abgeleitet werden,

$$\mathrm{mit} \quad z \quad = \quad e^{pT},$$

worin p die komplexe Frequenz und T die Abtastperiode ist.

Fig.1

Stufe 1    Stufe 2    Stufe 3    Verknüpfungsstufe

EP 0 406 693 A2

Fig. 2

Fig. 3

Fig. 4

Fig. 5

EP 0 406 693 A2

Fig.6

Transformation

I

II

S2

S2'

S2'

EP 0 406 693 A2